# EUROPEAN PATENT APPLICATION

(11) **EP 4 844 113 A1**
(43) Date of publication of application: **25.11.2026**
(21) Application number: 26159610.0
(22) Date of filing: 19.02.2026
(51) Int. Cl.: C30B 29/36, C30B 19/02, C30B 19/10

(54) **SINGLE CRYSTAL, SILICON CARBIDE SUBSTRATE, SILICON CARBIDE WAFER, AND METHOD OF MANUFACTURING SINGLE CRYSTAL**

(30) Priority: 23.05.2025 JP 2025086621
(71) Applicant: Proterial, Ltd., Tokyo 135-0061 (JP)
(72) Inventor: ABE, Mai, Tokyo, 135-0061 (JP); KUSUNOKI, Kazuhiko, Tokyo, 135-0061 (JP)
(74) Representative: Locas, Davide

(57) **Abstract**

Both the decrease in the specific resistance of the silicon carbide single crystal and the stability of the polytype are achieved. When the n-type silicon carbide single crystal having the "4H" polytype is manufactured by the solution growth method, the solution containing boron is used.

## Description

### CROSS-REFERENCE TO RELATED APPLICATION

The present application claims priority from Japanese Patent Application No. 2025-86621 filed on May 23, 2025, the content of which is hereby incorporated by reference into this application.

### TECHNICAL FIELD OF THE INVENTION

The present disclosure relates to a single crystal, a silicon carbide substrate, a silicon carbide wafer, and a method of manufacturing the single crystal. The present disclosure relates to, for example, a solution growth method.

### BACKGROUND OF THE INVENTION

Japanese Patent Application Laid-Open Publication No. 2015-30640 (Patent Document 1) describes doping with nitrogen and aluminum when a single crystal made of silicon carbide is formed by a physical vapor transport method.

Japanese Patent Application Laid-Open Publication No. 2020-33230 (Patent Document 2) describes doping with nitrogen and boron when a single crystal made of silicon carbide is formed by a physical vapor transport method.

### SUMMARY OF THE INVENTION

The solution growth method has been known as a method of manufacturing a single crystal made of silicon carbide.

The solution growth method is a technique of growing the single crystal on the surface of a seed crystal made of silicon carbide by lowering the temperature in the vicinity of the seed crystal while bringing the surface of the seed crystal into contact with a solution containing carbon and silicon. In the solution growth method, the single crystal is grown in a state close to a thermodynamic equilibrium state. Accordingly, the single crystal manufactured by the solution growth method has a significantly low defect density.

The single crystal made of silicon carbide is hereinafter referred to as a silicon carbide single crystal.

A silicon carbide substrate is obtained by slicing the silicon carbide single crystal. A semiconductor device is manufactured using the silicon carbide substrate. The semiconductor device is, for example, a power MOSFET (metal oxide semiconductor field effect transistor), an IGBT (insulated gate bipolar transistor), a p-n junction diode or others.

Particularly, the power MOSFET has superior in switching performance in a switching property and high-temperature resistance. Accordingly, the power MOSFET among the semiconductor devices is most frequently used. An n-type silicon carbide substrate is used to manufacture the power MOSFET. Therefore, in order to manufacture a high-performance power MOSFET, a high-quality n-type silicon carbide substrate needs to be used. The n-type silicon carbide substrate is obtained by slicing a silicon carbide single crystal. Accordingly, in order to manufacture a high-quality power MOSFET, a high-quality silicon carbide single crystal is desired.

Specifically, the high-performance power MOSFET is a power MOSFET having a small on-resistance. Therefore, a silicon carbide single crystal having a low resistance is desired.

In order to manufacture the n-type silicon carbide single crystal, the silicon carbide single crystal is doped with nitrogen as a donor. A specific resistance of the silicon carbide single crystal depends on a doping concentration of the nitrogen. Increase in the concentration of nitrogen in the silicon carbide single crystal decreases the specific resistance of the silicon carbide single crystal decreases. Accordingly, in order to decrease the specific resistance of the silicon carbide single crystal, it is desirable to increase the concentration of nitrogen in the silicon carbide single crystal.

However, the increase in the concentration of nitrogen in the silicon carbide single crystal makes a polytype of the silicon carbide unstable. Particularly, in the solution growth method, it is difficult to make the polytype stable. For example, the polytype changes from "4H" to other polytype such as "6H". In this case, the silicon carbide grown by the solution growth method cannot be used to manufacture the semiconductor device. Thus, in use of the solution growth method, it is desirable to achieve both the decrease in the specific resistance of the silicon carbide single crystal and the stability of the polytype.

Note that the silicon carbide single crystal is also referred to as a "boule". The boule is synonymous with a silicon carbide ingot. Therefore, the silicon carbide single crystal is also synonymous with the silicon carbide ingot.

In an embodiment, a silicon carbide single crystal is a single crystal made of silicon carbide having a 4H polytype. The single crystal contains nitrogen and boron. A concentration of nitrogen in the silicon carbide single crystal is higher than a concentration of boron in the silicon carbide single crystal. The concentration of nitrogen in the silicon carbide single crystal is 1.0 × 10¹⁸ atoms/cm³ or more and 4.0 × 10¹⁹ atoms/cm³ or less. The concentration of boron in the silicon carbide single crystal is 1.0 × 10¹⁷ atoms/cm³ or more and 4.0 × 10¹⁸ atoms/cm³ or less.

In an embodiment, a silicon carbide substrate is made of silicon carbide having a 4H polytype. The silicon carbide substrate contains nitrogen and boron. A concentration of nitrogen in the silicon carbide single crystal is higher than a concentration of boron in the silicon carbide single crystal. The concentration of nitrogen in the silicon carbide single crystal is 1.0 × 10¹⁸ atoms/cm³ or more and 4.0 × 10¹⁹ atoms/cm³ or less. The concentration of boron in the silicon carbide single crystal is 1.0 × 10¹⁷ atoms/cm³ or more and 4.0 × 10¹⁸ atoms/cm³ or less.

In an embodiment, a silicon carbide wafer includes the above-described silicon carbide substrate and an epitaxial layer formed on the silicon carbide substrate.

In an embodiment, a method of manufacturing a single crystal includes a step (a) of preparing a solution containing carbon, silicon, and boron, and a step (b) of preparing a seed crystal that is a silicon carbide single crystal and has a surface. The method of manufacturing the single crystal includes a step (c) of bringing the surface into contact with a liquid surface of the solution, a step (d) of forming a grown crystal from the surface, and a step (e) of obtaining a single crystal containing the grown crystal by terminating growth of the grown crystal. In the step (d), nitrogen and boron are incorporated into the grown crystal. The grown crystal formed in the step (d) is made of silicon carbide having a 4H polytype, and contains nitrogen and boron.

According to an embodiment, in use of a solution growth method, both decrease in a specific resistance of the silicon carbide single crystal and stability of the polytype can be achieved.

### BRIEF DESCRIPTIONS OF THE DRAWINGS

FIG. 1 is a diagram illustrating a configuration of a single crystal manufacturing apparatus;
FIG. 2 is a flowchart illustrating a method of manufacturing a silicon carbide single crystal;
FIG.3 is a diagram illustrating a state where a crucible and a seed crystal are placed in the single crystal manufacturing apparatus;
FIG. 4 is a diagram illustrating a state where a front surface of the seed crystal is brought into contact with a liquid surface of a solution;
FIG. 5 is a graph plotting the relationship between the concentration of nitrogen in the silicon carbide single crystal and the concentration of boron in the silicon carbide single crystal for each of working examples and comparative examples; and
FIG. 6 is a graph in which a relationship between a difference between the concentration of nitrogen in the silicon carbide single crystal and the concentration of boron in the silicon carbide single crystal and a specific resistance in each of the working examples and the comparative examples.

### DESCRIPTIONS OF THE PREFERRED EMBODIMENTS

The same components are denoted by the same reference symbols throughout all the drawings for describing the embodiments, and the repetitive description thereof will be omitted. Note that hatching may be used even in a plan view so as to make the drawings easy to see.

### <Configuration of Single Crystal Manufacturing Apparatus>

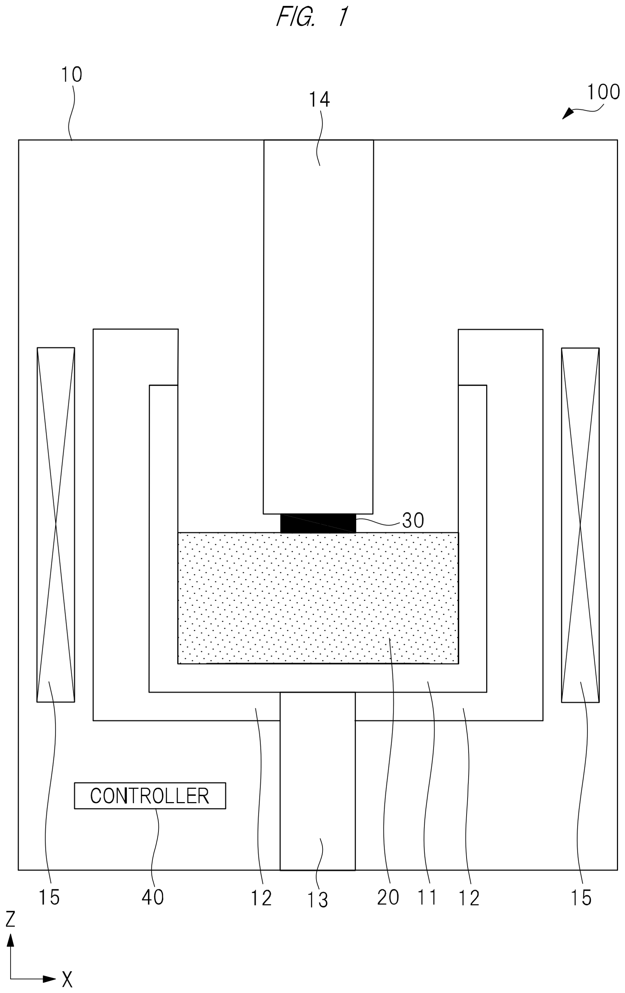

FIG. 1 is a diagram illustrating a configuration of a single crystal manufacturing apparatus 100.

The single crystal manufacturing apparatus 100 includes a container 10. An internal space of the container 10 is filled with, for example, helium gas or argon gas. A thermal insulation member 12 is provided inside the container 10. The container 10 is made of an iron-based material such as stainless steel. A crucible 11 is arranged in an inner portion surrounded by the thermal insulation member 12. The crucible 11 is made of graphite. A high-temperature solution 20 containing silicon (Si) is held in the crucible 11. The crucible 11 is held by a crucible holding shaft 13.

The crucible holding shaft 13 is configured to be movable in an up-down direction. The crucible holding shaft 13 is configured to be rotatable both clockwise and counterclockwise. In this manner, the crucible 11 can be moved in the up-down direction by the crucible holding shaft 13. Also, the crucible 11 can rotate in a horizontal direction.

A coil 15 through which a high-frequency current flows is provided outside the thermal insulation member 12. The crucible 11 is heated by induction heating based on the high-frequency current flowing through the coil 15. Note that the coil 15 is configured to allow a coolant to flow inside.

The single crystal manufacturing apparatus 100 includes a controller 40. An operation of the single crystal manufacturing apparatus 100 is controlled by the controller 40. For example, the controller 40 controls the high-frequency current flowing through the coil 15. In this manner, heating of the solution 20 held in the crucible 11 is controlled. The solution 20 is at a high temperature. Accordingly, graphite (C) making up the crucible 11 dissolves. Thus, the solution 20 contains carbon and silicon.

The single crystal manufacturing apparatus 100 includes a crystal holding shaft 14. The crystal holding shaft 14 is movable in the up-down direction. The crystal holding shaft 14 may be configured to be rotatable clockwise and counterclockwise as similar to the crucible holding shaft 13. That is, the presence or absence of the rotation mechanism in the crystal holding shaft 14 and the crucible holding shaft 13 is optional.

A seed crystal 30 is attached to a tip of the crystal holding shaft 14. The seed crystal 30 has a front surface and a rear surface. The rear surface of the seed crystal 30 is fixed to the crystal holding shaft 14. Note that the seed crystal 30, together with a graphite holder (not illustrated), may be fixed to the crystal holding shaft 14 while adhering to the graphite holder. The front surface of the seed crystal 30 faces the liquid surface of the solution 20.

The controller 40 performs control to move the crystal holding shaft 14 in the up-down direction. The controller 40 moves the crystal holding shaft 14, having the tip to which the seed crystal 30 has been attached, in the down direction. In this manner, the front surface of the seed crystal 30 can be brought into contact with the liquid surface of the solution 20. After bringing the front surface of the seed crystal 30 into contact with the liquid surface of the solution 20, the controller 40 moves the crystal holding shaft 14 in the up direction. In this manner, a silicon carbide single crystal is grown on the front surface of the seed crystal 30.

It is sufficient that the seed crystal 30 is brought into contact with the solution 20. Particularly, it is desirable to bring the seed crystal 30 in contact with the liquid surface of the solution 20. For example, the silicon carbide single crystal can be grown on the front surface of the seed crystal 30 by moving the crystal holding shaft 14 in the up direction. For example, the silicon carbide single crystal may be grown on the front surface of seed crystal 30 while the crystal holding shaft 14 is stopped (maintained). Alternatively, the silicon carbide single crystal can also be grown on the front surface of the seed crystal 30 by moving the crystal holding shaft 14 in the down direction. This configuration is made in consideration of a case in which the liquid surface of the solution 20 may be lowered by vaporization of the solution 20. That is, if the liquid surface of the solution 20 is lowered by the vaporization of the solution 20, the single crystal is grown while the crystal holding shaft 14 is moved in the down direction. In this manner, the single crystal can be reliably grown on the seed crystal 30. The single crystal manufacturing apparatus 100 is configured as described above.

### <Method of manufacturing Silicon Carbide Single Crystal>

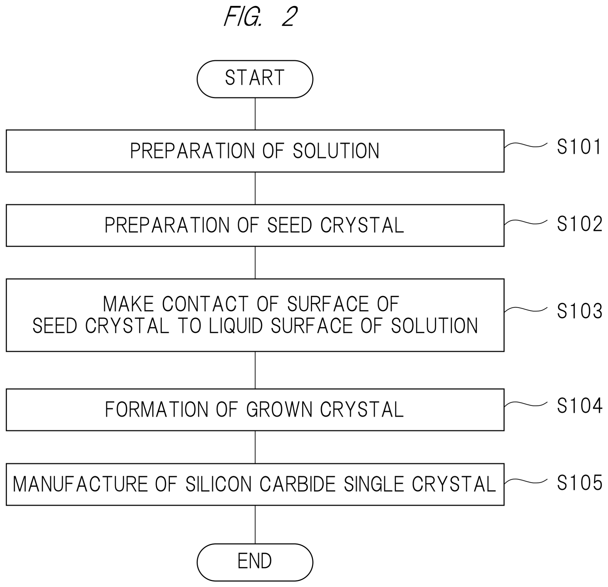

FIG. 2 is a flowchart illustrating a method of manufacturing the silicon carbide single crystal.

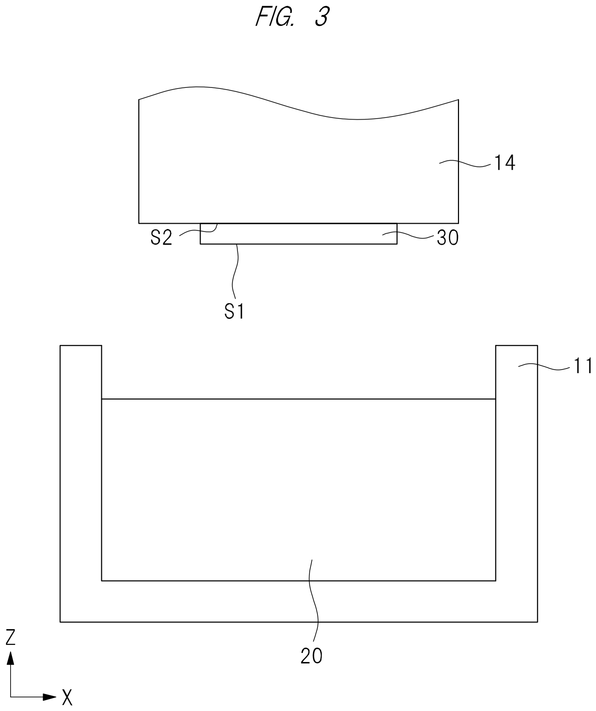

First, the solution containing carbon and silicon is prepared (S101). The seed crystal is prepared (S102). Specifically, FIG. 3 is a diagram illustrating a state where the crucible 11 and the seed crystal 30 are arranged in the single crystal manufacturing apparatus. The crucible 11 is made of graphite. The solution 20 is held inside the crucible 11. The solution 20 contains silicon. The graphite making up the crucible 11 dissolves into the solution 20. As a result, the solution 20 contains carbon and silicon.

The seed crystal 30 is attached to the tip of the crystal holding shaft 14. The seed crystal 30 is made of silicon carbide. Specifically, the seed crystal 30 is made of silicon carbide having the 4H polytype. The seed crystal 30 has the front surface S1 and the rear surface S2. The front surface S1 is a surface on which the grown crystal made of silicon carbide is formed. The rear surface S2 is a surface opposite to the front surface S1. The rear surface S2 is fixed to the crystal holding shaft 14.

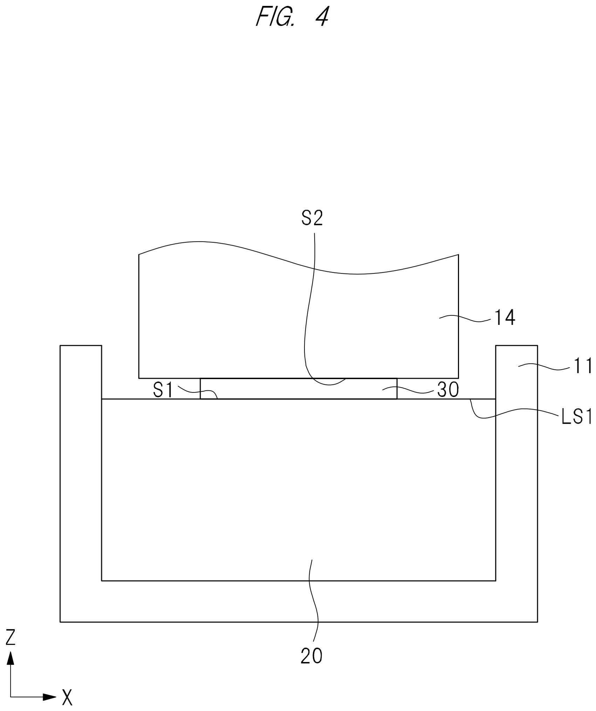

Then, the front surface of the seed crystal is brought into contact with the liquid surface of the solution 20 (S103). FIG. 4 is a diagram illustrating a state where the front surface S1 of the seed crystal 30 is brought into contact with the liquid surface LS1 of the solution 20. The front surface S1 can be brought into contact with the liquid surface LS1 by, for example, moving the crystal holding shaft 14 in the down direction (- Z-direction) to descend the seed crystal 30. However, the crucible 11 may be ascended by moving a crucible holding shaft 13 illustrated in FIG. 1 in the up direction (+ Z-direction).

Note that surfaces of the silicon carbide surface include the (0001) surface (Si-face) from which a silicon dangling bond is exposed and the (000-1) surface (C-face) from which a carbon dangling bond is exposed. The front surface S1 of the seed crystal 30 may be either the (000-1) surface (C-face) or the (0001) surface (Si-face). If the front surface S1 of the seed crystal 30 is the (000-1) surface (C-face), the height of growth steps can be decreased.

Then, the grown crystal is formed from the front surface S1 of the seed crystal 30 (S104). The silicon carbide single crystal is manufactured (S105) as described above.

In the present specification, the silicon carbide single crystal includes the grown crystal. Note that the silicon carbide single crystal may include the seed crystal 30. In this case, when it is assumed that a first surface of the grown crystal is a surface being in contact with the seed crystal 30, a second surface of the grown crystal opposite to the first surface is a crystal growth end surface. The front surface S1 of the seed crystal 30 is the (000-1) surface (C-face) or the (0001) surface (Si-face). For example, when it is assumed that the silicon carbide single crystal includes the seed crystal 30 and the grown crystal, if the surface S1 of the seed crystal 30 is the (000-1) surface (C-face), the first surface of the grown crystal is in contact with the (000-1) surface (C-face). On the other hand, if the surface S1 of the seed crystal 30 is the (0001) surface (Si-face), the first surface of the grown crystal is in contact with the (0001) surface (Si-face).

### <New Findings Found out by Inventors>

In order to decrease the specific resistance of the n-type silicon carbide single crystal, it is necessary to increase the doping concentration of nitrogen in the silicon carbide single crystal. However, the increase in the concentration of nitrogen in the silicon carbide single crystal makes the polytype of silicon carbide unstable. Particularly, in the solution growth method, it is difficult to stabilize the polytype.

In this regard, it is known that the "4H" polytype is stabilized by performing doping with aluminum together with nitrogen into the silicon carbide single crystal. However, aluminum has low melting and boiling points. Accordingly, aluminum as dopant in the solution inside the crucible easily vaporizes from the solution when being exposed to high temperature to grow the crystal for a long time. This results in change of the concentration of aluminum in the solution. In this manner, an amount of aluminum contained in the grown crystal is changed.

Therefore, the present inventors have studied a material capable of improving the stability of the polytype. As a result of the study, the inventors have newly found out that the "4H" polytype can be stabilized by doping with boron as a similar acceptor to aluminum into the silicon carbide single crystal. That is, the present inventors have newly found out that the "4H" polytype can be stabilized by doping with not only nitrogen but also boron rather than doping with only nitrogen in the n-type silicon carbide single crystal.

Particularly, the melting and boiling points of boron are higher than the melting and boiling points of aluminum. Accordingly, boron as dopant into the solution inside the crucible is more difficult to vaporize from the solution than aluminum even when being exposed to high temperature to grow the crystal for a long time. This results in less change of the concentration of boron in the solution. In this manner, an amount of boron contained in the grown crystal is made uniform. In this regard, boron is superior to aluminum.

For example, the Patent Document 2 described in the chapter "BACKGROUND OF THE INVENTION" describes doping with nitrogen and boron when the silicon carbide single crystal is formed by the physical vapor transport method. The Patent Document 2 describes that a basal plane dislocation density in the silicon carbide single crystal can be decreased by doping with nitrogen and boron into the silicon carbide single crystal. That is, in the Patent Document 2, doping with nitrogen and boron is performed in order to decrease the basal plane dislocation density in the silicon carbide single crystal. In other words, the Patent Document 2 neither describes nor teaches that doping with boron is performed in order to stabilize the "4H" polytype. It is newly found out by the inventors that the "4H" polytype is stabilized by doping with not only nitrogen but also boron in the n-type silicon carbide single crystal.

The concentration of boron described in the Patent Document 2 is high. In the crystal growth, the concentration of boron is desirably as low as possible. This is because the lower the concentration of boron is, the less easily the defects occur in the silicon carbide single crystal. In this regard, the present inventors have newly found out that the "4H" polytype can be stabilized even if the concentration of boron is low. Therefore, the concentration of boron is desirably low from the viewpoint of stabilizing the "4H" polytype while suppressing the defects occurring in the silicon carbide single crystal. Further, decrease in the concentration of boron can also decrease a raw material cost. Accordingly, the decrease in the concentration of boron leads to reduction in the manufacturing cost of the silicon carbide single crystal.

In this regard, the physical vapor transport method is difficult to control the concentration of boron to the low concentration. On the other hand, the present inventors have newly found out that doping with boron having a low concentration can be performed into the silicon carbide single crystal by the solution growth method. A technical idea of the present disclosure will be described below.

### <Basic Idea>

A basic idea is based on the following findings.
(1) In the n-type silicon carbide single crystal to which doping with nitrogen is performed at a high concentration, the specific resistance of the silicon carbide single crystal can be decreased. On the other hand, the high doping concentration of the nitrogen makes the "4H" polytype unstable.
(2) The "4H" polytype can be stabilized by doping with boron having a lower concentration than the concentration of nitrogen into the n-type silicon carbide single crystal to which doping with nitrogen is performed.
(3) In order to decrease defects occurring in the silicon carbide single crystal, the doping concentration of boron into the silicon carbide single crystal is desirably as low as possible.
(4) In the physical vapor transport method, there is a tendency that it is more difficult to perform doping with aluminum or boron than nitrogen. Accordingly, the physical vapor transport method is difficult to control the concentration of boron to a low concentration.
(5) In the solution growth method, doping with boron is performed from the solution into the grown crystal by dissolving boron into the solution. In this method, the concentration of boron incorporated into the grown crystal can be adjusted to the low concentration by adjusting the amount of boron introduced into the solution. This is a finding found out by the present inventors.
(6) The melting point of boron is higher than the melting point of aluminum. The boiling point of boron is higher than the boiling point of aluminum. Thus, use of boron as a dopant element into the silicon carbide single crystal in order to stabilize the "4H" polytype is advantageous.

The basic idea based on the above findings is to use the solution containing boron when manufacturing the n-type silicon carbide single crystal having the "4H" polytype by the solution growth method. The concentration of boron contained in the silicon carbide single crystal can be adjusted by controlling the amount of boron introduced into the solution. Therefore, according to the basic idea, the concentration of boron can be adjusted to the low concentration capable of decreasing the defects occurring in the silicon carbide single crystal while making the "4H" polytype stable.

An embodiment in which the basic idea is embodied will be described below.

### <Embodiment>

### < <Method of manufacturing Silicon Carbide Single Crystal> >

In the embodiment, a method of manufacturing the silicon carbide single crystal is basically illustrated in the flowchart of FIG. 2. A feature of the embodiment will be particularly mainly described below.

### 1. Doping with Boron

The solution prepared in S101 illustrated in FIG. 2 contains carbon, silicon, and boron. The boron introduced into the solution may be in the form of elemental boron. However, a form of boron introduced into the solution is not limited to this. For example, the boron introduced into the solution may be supplied in the form of a boron compound such as B₄C, BM_{O}, or BCr. The concentration of boron in the solution can be controlled by adjusting the amount of elemental boron or the amount of the boron compound introduced into the solution. Boron is incorporated into the grown crystal in the formation of the grown crystal illustrated in S104 in FIG. 2.

### 2. Metal elements suitable for addition to Solution

Chromium may be added to the solution. The introduction of chromium into the solution is performed in order to, for example, improve a growth speed in forming the grown crystal in S104 illustrated in FIG. 2. Additionally, other metal elements may be introduced into the solution. The metal element may be, for example, molybdenum, nickel, cobalt, tungsten or others.

For example, when it is assumed that a total amount of silicon, chromium, boron, and the metal element in the solution is set to 100 atom%, a content of chromium is 0.5 atom% or more and less than 40 atom%. A content of boron is 0.05 atom% or more and less than 3 atom%.

Molybdenum and tungsten each have a function of suppressing roughness of the crystal growth surface in the formation process of the grown crystal. The large roughness of the crystal growth surface leads to making the polytype unstable. Therefore, the introduction of molybdenum and/or tungsten into the solution is effective for making the polytype stable.

A rare-earth element may be added to the solution. The rare-earth element is, for example, yttrium, lanthanum, cerium, praseodymium, neodymium, samarium, gadolinium, terbium, dysprosium, thulium or others.

The above-described rare-earth element has a function of suppressing roughness of the crystal growth surface in the formation process of the grown crystal. The large roughness of the crystal growth surface leads to making the polytype unstable. Therefore, the introduction of the rare-earth element into the solution is effective for making the polytype stable.

### 3. Doping with Nitrogen

Nitrogen is present in the atmosphere. The container 10 in the single crystal manufacturing apparatus 100 illustrated in FIG. 1 is filled with, for example, helium gas or argon gas. However, the inside of the single crystal manufacturing apparatus 100 may be exposed to the atmosphere containing nitrogen before being filled with helium gas or argon gas. Accordingly, nitrogen adheres to the thermal insulation member 12 arranged inside the single crystal manufacturing apparatus 100. Nitrogen also adheres to the crucible 11 arranged inside the single crystal manufacturing apparatus 100. Such nitrogen described above is incorporated into the grown crystal in the method of manufacturing the silicon carbide single crystal using the single crystal manufacturing apparatus 100. That is, in the formation of the grown crystal illustrated in S104 in FIG. 2, nitrogen released from the thermal insulation member 12 or the crucible 11 is incorporated into the grown crystal. As described above, nitrogen is incorporated into the grown crystal.

Even if the single crystal manufacturing apparatus 100 is intentionally not doped with nitrogen, nitrogen as a background is incorporated into the grown crystal. In the present specification, the term "background" is used to represent a situation where nitrogen is unintentionally present inside the single crystal manufacturing apparatus 100 even if the single crystal manufacturing apparatus 100 is not intentionally doped with nitrogen.

Thus, in the embodiment, nitrogen as the background is incorporated into the grown crystal in the formation of the grown crystal illustrated in S104 in FIG. 2.

However, the single crystal manufacturing apparatus 100 may be intentionally doped with nitrogen. For example, the grown crystal may be formed as illustrated in S104 in FIG. 2 under an atmosphere where nitrogen of 50 ppm or less is contained in inert gas containing helium gas or argon gas. In this case, nitrogen is incorporated into the grown crystal from the atmosphere containing nitrogen of 50 ppm or less.

### 4. Temperature of Solution

In the formation of the grown crystal illustrated in S104 in FIG. 2, the temperature of the solution is 1900 degrees Celsius or higher and 2300 degrees Celsius or lower.

As described above, the grown crystal formed in S104 illustrated in FIG. 2 is made of silicon carbide having the **4H** polytype, and contains nitrogen and boron. Then, as illustrated in S105 in FIG. 2, the silicon carbide single crystal containing the grown crystal is obtained after the end of the growth of the grown crystal.

Then, a configuration of the silicon carbide single crystal manufactured in the embodiment will be described.

### < <Configuration of Silicon Carbide Single Crystal> >

The silicon carbide single crystal is made of silicon carbide having the 4H polytype. The silicon carbide single crystal contains nitrogen as a donor and boron as an acceptor. The concentration of nitrogen in the silicon carbide single crystal is higher than the concentration of boron in the silicon carbide single crystal. Therefore, the concentration of the donor is higher than the concentration of the acceptor. Accordingly, the silicon carbide single crystal is of an "n" type. The concentration of nitrogen in the silicon carbide single crystal is 1.0 × 10¹⁸ atoms/cm³ or more and 4.0 × 10¹⁹ atoms/cm³ or less. The concentration of boron in the silicon carbide single crystal is 1.0 × 10¹⁷ atoms/cm³ or more and 4.0 × 10¹⁸ atoms/cm³ or less.

As a result, according to the embodiment, the silicon carbide single crystal having the low specific resistance can be manufactured. Specifically, the specific resistance of the silicon carbide single crystal is 10 mΩ·cm or more and 25 mΩ·cm or less. According to the embodiment, the silicon carbide single crystal is doped with boron. Accordingly, the 4H polytype can be stabilized in the silicon carbide single crystal. Further, the concentration of boron in the silicon carbide single crystal is low, and therefore, the defects occurring in the silicon carbide single crystal can be decreased.

The concentration of nitrogen in the silicon carbide single crystal and the concentration of boron in the silicon carbide single crystal are desirably as follows.

The concentration of nitrogen in the silicon carbide single crystal is 5.0 × 10¹⁸ atoms/cm³ or more and 4.0 × 10¹⁹ atoms/cm³ or less. The concentration of boron in the silicon carbide single crystal is 1.0 × 10¹⁷ atoms/cm³ or more and 1.0 × 10¹⁸ atoms/cm³ or less.

The concentration of nitrogen in the silicon carbide single crystal and the concentration of boron in the silicon carbide single crystal are further desirably as follows.

The concentration of nitrogen in the silicon carbide single crystal is 5.0 × 10¹⁸ atoms/cm³ or more and 2.0 × 10¹⁹ atoms/cm³ or less. The concentration of boron in the silicon carbide single crystal is 2.0 × 10¹⁷ atoms/cm³ or more and 1.0 × 10¹⁸ atoms/cm³ or less.

In the solution growth method, the solution may be doped with chromium. Accordingly, the silicon carbide single crystal manufactured by the solution growth method may contain chromium.

### < <Method of manufacturing Silicon Carbide Substrate> >

A method of manufacturing the silicon carbide substrate includes a step of preparing the silicon carbide single crystal manufactured by the method of manufacturing of the silicon carbide single crystal according to the present disclosure, and a step of obtaining the silicon carbide substrate by slicing the silicon carbide single crystal. In this manner, the silicon carbide substrate can be manufactured from the silicon carbide single crystal having the low specific resistance and having the stable "4H" polytype. As a result, the high-quality silicon carbide substrate having the low specific resistance and having the stable "4H" polytype can be achieved.

Specifically, the silicon carbide substrate having the following configurations can be manufactured.
(1) The silicon carbide substrate is made of the silicon carbide having the **4H** polytype.
(2) The silicon carbide substrate contains nitrogen and boron.
(3) The concentration of nitrogen in the silicon carbide single crystal is higher than the concentration of boron in the silicon carbide single crystal.
(4) The concentration of nitrogen in the silicon carbide single crystal is 1.0 × 10¹⁸ atoms/cm³ or more and 4.0 × 10¹⁹ atoms/cm³ or less.
(5) The concentration of boron in the silicon carbide single crystal is 1.0 × 10¹⁷ atoms/cm³ or more and 4.0 × 10¹⁸ atoms/cm³ or less.

### <Method of manufacturing Silicon Carbide Wafer>

In the present specification, a silicon carbide substrate on which an epitaxial layer is formed is referred to as the "silicon carbide wafer". A method of manufacturing the silicon carbide wafer includes a step of preparing the silicon carbide substrate manufactured by the above-described method of manufacturing the silicon carbide substrate, and a step of forming the epitaxial layer as the silicon carbide single crystal on the silicon carbide substrate.

Specifically, the silicon carbide substrate in the present disclosure is prepared. The silicon carbide substrate is, for example, the n-type substrate having the "4H" polytype. The silicon carbide substrate has the (0001) surface (Si-face) and the (000-1) surface (C-face). An upper surface of the silicon carbide substrate may be either the (0001) surface (Si-face) or the (000-1) surface (C-face).

Then, the epitaxial layer is formed on the silicon carbide substrate. The epitaxial layer includes, for example, a buffer layer formed on the silicon carbide substrate and a drift layer formed on the buffer layer. The buffer layer and the drift layer can be formed by using, for example, an epitaxial growth method. And, for example, each of the buffer layer and the drift layer is doped with nitrogen as an n-type impurity. An impurity doping concentration of nitrogen into the drift layer is lower than an impurity doping concentration of nitrogen into the buffer layer. The impurity concentration of the drift layer depends on a rating of the semiconductor device manufactured using the silicon carbide wafer. As described above, the silicon carbide wafer can be manufactured.

### <Method of manufacturing Semiconductor Device>

A method of manufacturing the semiconductor device includes a step of preparing the silicon carbide wafer manufactured by the above-described method of manufacturing the silicon carbide wafer and a step of manufacturing the semiconductor device using the silicon carbide wafer. The silicon carbide wafer has, for example, the "4H" polytype.

Typical silicon carbide polytypes are "4H", "6H", "3C", "15R" and others. In this regard, the "4H" polytype among these polytypes has the largest band gap. Accordingly, when the semiconductor device is manufactured using the silicon carbide wafer having the "4H" polytype, the performance of the semiconductor device can be improved.

The semiconductor device can be manufactured by performing a deposition step, a heating step, an ion implantation step, an etching step, and a photolithography step and others to the silicon carbide wafer.

In the silicon carbide wafer in the present disclosure, for example, both the silicon carbide substrate and the epitaxial layer each have the "4H" polytype. Accordingly, the band gap of the epitaxial layer is large. The large bandgap of the epitaxial layer means that a dielectric breakdown voltage can be ensured even if the thickness of the epitaxial layer is decreased. That is, it is unnecessary to increase the thickness of the epitaxial layer for ensuring the dielectric breakdown voltage. Accordingly, since the thickness of the epitaxial layer can be decreased, an on-resistance of the semiconductor device can be decreased.

Therefore, when the silicon carbide wafer having the "4H" polytype is used, a semiconductor device capable of achieving both the improvement in the dielectric breakdown voltage and the decrease in the on-resistance which are in a trade-off relationship can be manufactured. The semiconductor device is, for example, a power MOSFET.

In the present disclosure, the silicon carbide wafer having the small specific resistance is manufactured. The semiconductor device is manufactured using the silicon carbide wafer in the present disclosure. Accordingly, the on-resistance of the semiconductor device can be decreased. That is, the achievement of manufacturing the silicon carbide single crystal having the small specific resistance ultimately leads to the improvement in the performance of the semiconductor device.

### <Effect Verification>

### <<Working Example 1, Working Example 2>>

A solution is held in a graphite crucible having an inner diameter of 90 mm and an outer diameter of 110 mm such that the height of the solution is about 25 mm. The solution contains silicon, chromium, boron, molybdenum, and lanthanum.

Assuming that the total amount of elements in the solution is set to 100 atom%, the atomic percentage of each element is as follows:
Silicon: 51 atom%
Chromium: 40 atom%
Boron: 1 atom%
Other elements including molybdenum and lanthanum: 8 atom%

A seed crystal having "φ50mm" and having a thickness of 750 µm is prepared. The seed crystal is the single crystal made of silicon carbide having the "4H" polytype.

The (0001) surface (Si-face) of the seed crystal is bonded to a graphite holder having a diameter of about 50 mm by a graphite adhesive such that a growth surface is the (000-1) surface (C-face). The graphite holder is attached to a rod made of graphite. The graphite holder and the rod made of graphite constitute a crystal holding shaft.

The inside of the single crystal manufacturing apparatus is vacuumed. Then, inert gas mixed with nitrogen of 50 ppm or less is introduced into the single crystal manufacturing apparatus to reach atmospheric pressure. In this state, the silicon carbide single crystal growth is performed.

The silicon carbide single crystal growth is performed by immersing the seed crystal into the solution, and then, holding the seed crystal at 2100 degrees Celsius for 16 hours while being immersed in the solution. At this time, the crystal holding shaft and the graphite crucible are rotated. The temperature distribution of the solution is adjusted such that the temperature of a side surface of the graphite crucible is high while the temperature of the seed crystal is low. The grown silicon carbide single crystal is lifted from the solution surface of the solution and is brought away from the solution. Then, the silicon carbide single crystal is cooled such that it takes one hour to slowly cool it. As described above, the silicon carbide single crystal is obtained.

### < <Working Example 3> >

This example is the same as the first and second working examples except for the following configuration.

Assuming that the total amount of elements in the solution is set to 100 atom%, the atomic percentage of each of the elements is as follows:
Silicon: 51.5 atom%
Chromium: 40 atom%
Boron: 0.5 atom%
Other elements including molybdenum and lanthanum: 8 atom%

A seed crystal having "φ40mm" and having a thickness of 750 µm is prepared.

The (0001) surface (Si-face) of the seed crystal is bonded to a graphite holder having a diameter of about 40 mm by a graphite adhesive such that a growth surface is the (000-1) surface (C-face).

The silicon carbide single crystal is formed by immersing the seed crystal into the solution, and then, holding the seed crystal at 2100 degrees Celsius for 32 hours while being immersed in the solution.

### <<Working Example 4> >

This example is the same as the first and second working examples except for the following configuration.

Assuming that the total amount of elements in the solution is set to 100 atom%, the atomic percentage of each of the elements is as follows:
Silicon: 51.75 atom%
Chromium: 40 atom%
Boron: 0.25 atom%
Other elements including molybdenum and lanthanum: 8 atom%

A seed crystal having "φ40mm" and having a thickness of 750 µm is prepared.

The (0001) surface (Si-face) of the seed crystal is bonded to a graphite holder having a diameter of about 40 mm by a graphite adhesive such that a growth surface is the (000-1) surface (C-face).

### <<Working Example 5, Working Example 6>>

These examples are the same as the first and second working examples except for the following configuration.

Assuming that the total amount of elements in the solution is set to 100 atom%, the atomic percentage of each of the elements is as follows:
Silicon: 51.9 atom%
Chromium: 40 atom%
Boron: 0.1 atom%
Other elements including molybdenum and lanthanum: 8 atom%

A seed crystal having "φ40mm" and having a thickness of 750 µm is prepared.

The (0001) surface (Si-face) of the seed crystal is bonded to a graphite holder having a diameter of about 40 mm by a graphite adhesive such that a growth surface is the (000-1) surface (C-face).

### <<Comparative Example 1> >

This example is the same as the first and second working examples except for the following configuration.

Assuming that the total amount of elements in the solution is set to 100 atom%, the atomic percentage of each of the elements is as follows:
Silicon: 51.9 atom%
Chromium: 40 atom%
Boron: 0.1 atom%
Other elements including molybdenum and lanthanum: 8 atom%

A seed crystal having "φ40mm" and having a thickness of 750 µm is prepared.

The (0001) surface (Si-face) of the seed crystal is bonded to a graphite holder having a diameter of about 40 mm by a graphite adhesive such that a growth surface is the (000-1) surface (C-face).

The inside of the single crystal manufacturing apparatus is vacuumed. Then, inert gas mixed with nitrogen of 2000 ppm is introduced into the single crystal manufacturing apparatus to reach atmospheric pressure. In this state, the silicon carbide single crystal is formed.

### < <Comparative Example 2>>

This example is the same as the first and second working examples except for the following configuration.

Assuming that the total amount of elements in the solution is set to 100 atom%, the atomic percentage of each of the elements is as follows:
Silicon: 47 atom%
Chromium: 40 atom%
Boron: 5 atom%
Other elements including molybdenum and lanthanum: 8 atom%

A seed crystal having "φ40mm" and having a thickness of 750 µm is prepared.

The (0001) surface (Si-face) of the seed crystal is bonded to a graphite holder having a diameter of about 40 mm by a graphite adhesive such that a growth surface is the (000-1) surface (C-face).

The inside of the single crystal manufacturing apparatus is vacuumed. Then, inert gas mixed with nitrogen of 1000 ppm is introduced into the single crystal manufacturing apparatus to reach atmospheric pressure. In this state, the silicon carbide single crystal is formed.

### <<Comparative Example 3>>

This example is the same as the first and second working examples except for the following configuration.

Assuming that the total amount of elements in the solution is set to 100 atom%, the atomic percentage of each element is as follows:
Silicon: 51 atom%
Chromium: 40 atom%
Boron: 1 atom%
Other elements including molybdenum and lanthanum: 8 atom%

A seed crystal having "φ40mm" and having a thickness of 750 µm is prepared.

The (0001) surface (Si-face) of the seed crystal is bonded to a graphite holder having a diameter of about 40 mm by a graphite adhesive such that a growth surface is the (000-1) surface (C-face).

The inside of the single crystal manufacturing apparatus is vacuumed. Then, inert gas mixed with nitrogen of 2000 ppm is introduced into the single crystal manufacturing apparatus to reach atmospheric pressure. In this state, the silicon carbide single crystal is formed.

### <<Comparative Example 4>>

This example is the same as the first and second working examples except for the following configuration.

Assuming that the total amount of elements in the solution is set to 100 atom%, the atomic percentage of each of the elements is as follows:
Silicon: 51.8 atom%
Chromium: 40 atom%
Boron: 0.2 atom%
Other elements including molybdenum and lanthanum: 8 atom%

A seed crystal having "φ40mm" and having a thickness of 750 µm is prepared.

The (0001) surface (Si-face) of the seed crystal is bonded to a graphite holder having a diameter of about 40 mm by a graphite adhesive such that a growth surface is the (000-1) surface (C-face).

The inside of the single crystal manufacturing apparatus is vacuumed. Then, inert gas mixed with nitrogen of 50 ppm is introduced into the single crystal manufacturing apparatus to reach atmospheric pressure. In this state, the silicon carbide single crystal is formed.

The silicon carbide single crystal is formed by immersing the seed crystal into the solution, and then, holding the seed crystal at 2000 degrees Celsius for 32 hours while being immersed in the solution.

### < <Validation Results> >

Table 1 is a table illustrating the temperature of the solution, the doping amount of boron, the doping amount of nitrogen, the concentration of boron in the silicon carbide single crystal, the concentration of nitrogen in the silicon carbide single crystal, the specific resistance, the polytype, and a determination result in each of the working examples and the comparative examples.

In the determination result in Table 1, a case providing a silicon carbide single crystal having a specific resistance of 10 mΩ·cm or more and 25 mΩ·cm or less and having the "4H" polytype is expressed as "good". In the determination result in Table 1, a case not providing the above-described silicon carbide single crystal is expressed as "poor".

**[Table 1]**

| | SOLUTION TEMPERATURE (°C) | INTRODUCED AMOUNT OF BORON (mol%) | INTRODUCED AMOUNT OF NITROGEN (mol%) | CONCENTRATION OF BORON IN SINGLE CRYSTAL (atoms/cm³) | CONCENTRATION OF NITROGEN IN SINGLE CRYSTAL (atoms/cm³) | SPECIFIC RESISTANCE mΩ · cm | POLYTYPE | DETERMINATION RESULT |
|---|---|---|---|---|---|---|---|---|
| COMPARATIVE EXAMPLE 1 | 2100 | 0.1 | 0.28 (2000ppm) | 1.85 × 10¹⁹ | 1.36 × 10²⁰ | 10 | 4H+6H+15R | POOR |
| COMPARATIVE EXAMPLE 2 | 2100 | 5 | 0.14 (1000ppm) | 1.35 × 10¹⁹ | 4.36 × 10¹⁹ | 26 | 4H+6H+15R | POOR |
| COMPARATIVE EXAMPLE 3 | 2100 | 1 | 0.28 (2000ppm) | 6.37 × 10¹⁸ | 2.08 × 10¹⁹ | 51 | 4H+6H+15R | POOR |
| COMPARATIVE EXAMPLE 4 | 2000 | 0.2 | 0.007 (50ppm) | 5.20 × 10¹⁷ | 4.59 × 10¹⁹ | 12 | 6H | POOR |
| WORKING EXAMPLE 1 | 2100 | 1 | 0.007 (50ppm) | 2.74 × 10¹⁸ | 2.09 × 10¹⁹ | 22 | 4H | GOOD |
| WORKING EXAMPLE 2 | 2100 | 1 | 0.007 (50ppm) | 3.71 × 10¹⁸ | 2.55 × 10¹⁹ | 19 | 4H | GOOD |
| WORKING EXAMPLE 3 | 2100 | 0.5 | 0.007 (50ppm) | 2.15 × 10¹⁸ | 3.48 × 10¹⁹ | 16 | 4H | GOOD |
| WORKING EXAMPLE 4 | 2100 | 0.25 | 0.007 (50ppm) | 1.00 × 10¹⁸ | 2.70 × 10¹⁹ | 20 | 4H | GOOD |
| WORKING EXAMPLE 5 | 2100 | 0.1 | 0.007 (50ppm) | 4.40 × 10¹⁷ | 2.96 × 10¹⁹ | 23 | 4H | GOOD |
| WORKING EXAMPLE 6 | 2100 | 0.1 | 0.007 (50ppm) | 2.21 × 10¹⁷ | 6.54 × 10¹⁸ | 22 | 4H | GOOD |

The comparative examples 1 to 4 each illustrate a case providing the concentration of boron in the silicon carbide single crystal and the concentration of nitrogen in the silicon carbide single crystal which are higher than optimal ranges. The optimal ranges are ranges providing a silicon carbide single crystal having a specific resistance of 10 mΩ·cm or more and 25 mΩ·cm or less and having the "4H" polytype. Specifically, the optimal range in the concentration of nitrogen in the silicon carbide single crystal is 1.0 × 10¹⁸ atoms/cm³ or more and 4.0 × 10¹⁹ atoms/cm³ or less. The optimal range in the concentration of boron in the silicon carbide single crystal is 1.0 × 10¹⁷ atoms/cm³ or more and 4.0 × 10¹⁸ atoms/cm³ or less.

In the comparative examples 1 to 3, the polytype is not stabilized to "4H". That is, the comparative examples 1 to 3 provide a plurality of different polytypes such as "6H" or "15R" other than "4H".

In the comparative examples 1 to 3, both the concentration of nitrogen in the silicon carbide single crystal and the concentration of boron in the silicon carbide single crystal are each 5.0 × 10¹⁸ atoms/cm³ or more. The increase in the concentrations of the donor and the acceptor included in the silicon carbide single crystal makes the crystal structure unstable. As a result, the increase in the concentrations of the donor and the acceptor included in the silicon carbide single crystal increases the defects and others. Accordingly, the increase in the concentrations of the donor and the acceptor makes the crystalline quality worse.

Therefore, the concentrations of the donor and the acceptor are desirably as low as possible in the range providing the silicon carbide single crystal having the specific resistance of 10 mΩ·cm or more and 25 mΩ·cm or less and having the "4H" polytype.

In the comparative example 4, the polytype changes to "6H". This may be because of the much higher concentration of nitrogen in the silicon carbide single crystal than the concentration of boron in the silicon carbide single crystal. Practically, it has been experimentally demonstrated that a phenomenon of change of the polytype to "6H" is observed when "the concentration of nitrogen in the silicon carbide single crystal - the concentration of boron in the silicon carbide single crystal" is 4.0 × 10¹⁹ atoms/cm³ or more. It can be said that this fact is supported by the result in the comparative example 4.

The working examples 1 to 6 provide the silicon carbide single crystal having the specific resistance of 10 mΩ·cm or more and 25 mΩ·cm or less and having the "4H" polytype. As a result, it has been confirmed that the working examples 1 to 6 provide the silicon carbide single crystal having good crystalline quality and having low resistance.

In the working examples 1 to 6, the concentration of boron in the silicon carbide single crystal and the concentration of nitrogen in the silicon carbide single crystal fall within the optimal ranges. As described above, the optimal range in the concentration of boron is 1.0 × 10¹⁸ atoms/cm³ or more and 4.0 × 10¹⁹ atoms/cm³ or less. The optimal range in the concentration of boron in the silicon carbide single crystal is 1.0 × 10¹⁷ atoms/cm³ or more and 4.0 × 10¹⁸ atoms/cm³ or less. Therefore, the results in the working examples 1 to 6 have supported the fact that the silicon carbide single crystal having the low specific resistance and having the "4H" polytype is provided when the concentration of boron in the silicon carbide single crystal and the concentration of nitrogen in the silicon carbide single crystal fall within the optimal ranges.

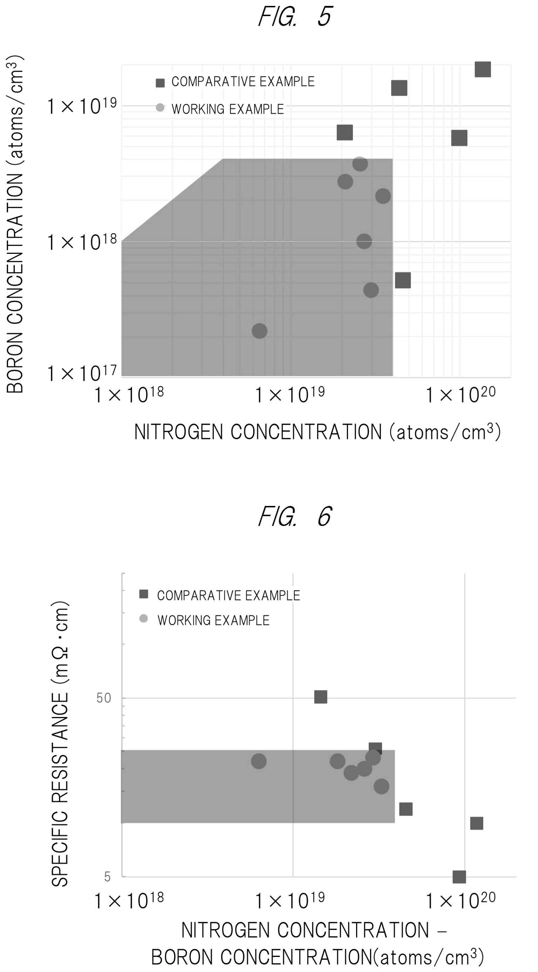

FIG. 5 is a graph plotting the relationship between the concentration of nitrogen in the silicon carbide single crystal and the concentration of boron in the silicon carbide single crystal for each of the working examples and the comparative examples. The region illustrated in grayscale indicates the optimal ranges.

The plots in the comparative examples are outside the optimal ranges. On the other hand, the plots in the working examples are within the optimal ranges. That is, the working examples achieve the concentration of boron in the silicon carbide single crystal and the concentration of nitrogen in the silicon carbide single crystal capable of achieving the aim.

FIG. 6 is a graph in which a relationship between the specific resistance and the difference between the concentration of nitrogen in the silicon carbide single crystal and the concentration of boron in the silicon carbide single crystal is plotted in each of the working examples and the comparative examples. A region illustrated with grayscale is a region providing the specific resistance of 10 mΩ·cm or more and 25 mΩ·cm or less.

The plots in the comparative examples are outside the region illustrated in grayscale. That is, the comparative examples do not achieve the specific resistance of 10 mΩ·cm or more and 25 mΩ·cm or less.

The plots in the working examples are within the region illustrated in grayscale. That is, the working examples achieve the specific resistance of 10 mΩ·cm or more and 25 mΩ·cm or less.

In the foregoing, the invention made by the inventors of the present invention has been concretely described based on the embodiments. However, it is needless to say that the present invention is not limited to the foregoing embodiments, and various modifications can be made within the scope of the present invention.

## Claims

1. A single crystal made of silicon carbide having a 4H polytype,
wherein the single crystal contains nitrogen and boron,
a concentration of the nitrogen is higher than a concentration of the boron,
the concentration of the nitrogen is 1.0 × 10¹⁸ atoms/cm³ or more and 4.0 × 10¹⁹ atoms/cm³ or less, and
the concentration of the boron is 1.0 × 10¹⁷ atoms/cm³ or more and 4.0 × 10¹⁸ atoms/cm³ or less.

2. The single crystal according to claim 1,
wherein the concentration of the nitrogen is 5.0 × 10¹⁸ atoms/cm³ or more and 4.0 × 10¹⁹ atoms/cm³ or less, and
the concentration of the boron is 1.0 × 10¹⁷ atoms/cm³ or more and 1.0 × 10¹⁸ atoms/cm³ or less.

3. The single crystal according to claim 2,
wherein the concentration of the nitrogen is 5.0 × 10¹⁸ atoms/cm³ or more and 2.0 × 10¹⁹ atoms/cm³ or less, and
the concentration of the boron is 2.0 × 10¹⁷ atoms/cm³ or more and 1.0 × 10¹⁸ atoms/cm³ or less.

4. The single crystal according to any of the preceding claims,
wherein a specific resistance of the single crystal is 10 mΩ·cm or more and 25 mΩ·cm or less.

5. The single crystal according to any of the preceding claims,
wherein the single crystal contains chromium.

6. A silicon carbide substrate made of silicon carbide having a 4H polytype,
wherein the silicon carbide substrate contains nitrogen and boron,
a concentration of the nitrogen is higher than a concentration of the boron,
the concentration of the nitrogen is 1.0 × 10¹⁸ atoms/cm³ or more and 4.0 × 10¹⁹ atoms/cm³ or less, and
the concentration of the boron is 1.0 × 10¹⁷ atoms/cm³ or more and 4.0 × 10¹⁸ atoms/cm³ or less.

7. A silicon carbide wafer comprising:
the silicon carbide substrate according to claim 6; and
an epitaxial layer formed on the silicon carbide substrate.

8. A method of manufacturing a single crystal, comprising steps of:
(a) preparing a solution containing carbon, silicon, and boron;
(b) preparing a seed crystal that is a silicon carbide single crystal and has a surface;
(c) bringing the surface into contact with a liquid surface of the solution;
(d) forming a grown crystal from the surface; and
(e) obtaining a single crystal containing the grown crystal by terminating growth of the grown crystal,
wherein in the step (d), nitrogen and the boron are incorporated into the grown crystal, and
the grown crystal formed in the step (d) is made of silicon carbide having a 4H polytype, and contains the nitrogen and the boron.

9. The method of manufacturing the single crystal according to claim 8,
wherein in the step (d), the nitrogen as a background is incorporated into the grown crystal.

10. The method of manufacturing the single crystal according to claim 8 or 9,
wherein the step (d) is performed under atmosphere containing the nitrogen of 50 ppm or less.

11. The method of manufacturing the single crystal according to any one of claims 8 to 10,
wherein the solution prepared in the step (a) contains chromium.

12. The method of manufacturing the single crystal according to claim 11,
wherein the solution contains a metal element,
when it is assumed that a total amount of the silicon, the chromium, the boron, and the metal element in the solution is set to 100 atom%, a content of the chromium is 0.5 atom% or more and less than 40 atom%, and
a content of the boron is 0.05 atom% or more and less than 3 atom%.

13. The method of manufacturing the single crystal according to any one of claims 8 to 12,
wherein in the step (d), a temperature of the solution is 1900 degrees Celsius or higher and 2300 degrees Celsius or lower.
